# EUROPEAN PATENT SPECIFICATION

(11) **EP 2 725 627 B1**
(45) Date of publication and mention of the grant of the patent: **10.08.2016**
(21) Application number: 12805221.4
(22) Date of filing: 22.06.2012
(51) Int. Cl.: H01L 31/048, C08J 5/18, C08K 5/5419

(54) **SOLAR CELL SEALING FILM AND SOLAR CELL USING THE SEALING FILM**
VERSIEGELUNGSFILM FÜR EINE SOLARZELLE UND SOLARZELLE MIT DEM VERSIEGELUNGSFILM
FILM DE SCELLEMENT ÉTANCHE POUR UNE CELLULE SOLAIRE ET CELLULE SOLAIRE L'UTILISANT

(30) Priority: 27.06.2011 JP 2011141416
(43) Date of publication of application: 30.04.2014
(73) Proprietor: Bridgestone Corporation, Tokyo 104-8340 (JP)
(72) Inventor: TOMIYAMA Makiko, Yokohama-shi Kanagawa 244-8510 (JP)
(74) Representative: Oxley, Robin John George
(86) International application number: PCT/JP2012/065959
(87) International publication number: WO 2013/002133

(56) References cited:
- EP-A1- 2 003 701
- WO-A1-2011/068188
- JP-A- 2009 200 385
- JP-A- 2011 044 626
- US-A1- 2004 181 007

## Description

### Technical Field

The present invention relates to a solar cell sealing film comprising chiefly ethylene-vinyl acetate copolymer, particularly a solar cell sealing film which is improved in insulation property under high-temperature environments.

### Background Art

In recent year, a solar cell (solar cell module) has been widely employed as a device directly converting solar energy into electric energy from the viewpoints of effective use of natural resources and prevention of environmental pollution. Further developments of solar cells are in progress with the object of power generation efficiency and residence to climate.

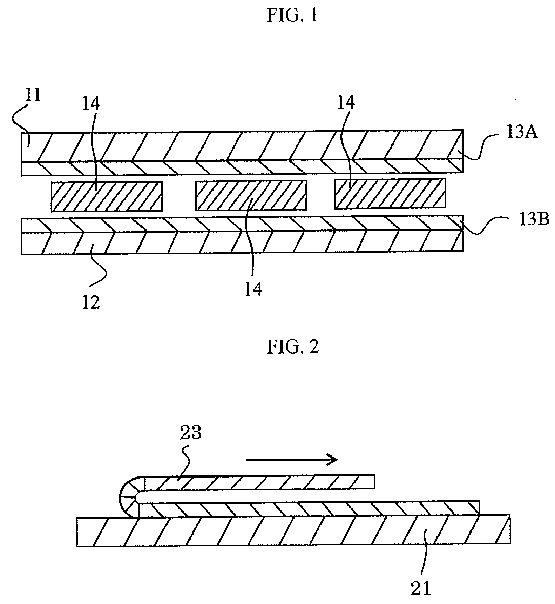

As shown in Fig. 1, a solar cell generally includes a transparent front side protection material 11 (e.g., glass plate), a front side sealing film 13A, photovoltaic elements 14 (e.g., photovoltaic elements made of silicon), a backside sealing film 13B and a backside protection material 12 (backside covering member). For preparing a solar cell, first, the foregoing members are successively laminated in this order. Then, the laminated body is subjected to vacuum degassing, subsequently, heating under pressure for adhesively combining the laminated body by cross-linking or curing a front side sealing film 13A and a backside sealing film 13B.

In order to generate a large electrical output, a solar cell has plural photovoltaic elements 14 connected to each other. Therefore, sealing films 13A, 13B having high insulation properties seal the photovoltaic elements for ensuring an electrical insulation property between the photovoltaic elements 14.

Further, developments of thin-film solar cells, such as thin-film silicon type solar cell, an amorphous silicon film type solar cell and copper indium selenide (CIS) type solar cell are also developed. These thin-film solar cells are prepared by, for example, forming a thin-film photovoltaic element such as a semiconductor layer on surface of a transparent material such as a glass substrate and a polyimide substrate by chemical vapor deposition method, etc., superposing a sealing film, etc. on the thin-film photovoltaic element and adhesively combining with the laminated body.

As a sealing film for the solar cells, a film made of ethylene-polar monomer copolymer such as ethylene-vinyl acetate copolymer (occasionally abbreviated to EVA) or ethylene-ethylacrylate copolymer (EEA) is used. Especially, the ethylene-vinyl acetate copolymer is preferably used because it has low cost and high transparency. Furthermore, in an EVA film used for a sealing film, the combination of cross-linkers such as organic peroxides with the EVA improves cross-link density for improvements of strength and durability of the film.

Such a solar cell is required to ensure collection of electricity generated by photovoltaic elements or thin-film photovoltaic elements (in the invention, they are generically referred to as photovoltaic elements) using incident solar light. Therefore, a solar cell sealing film is required to have high insulation properties to prevent a leakage of electricity for a long term period, and hence, the insulation properties have been improved so far.

For instance, Patent Document 1 discloses a solar cell sealing film having an improved insulation property as well as excellent transparency, thermal resistance and adhesiveness, which comprises a silane-coupling agent in the range of 0.03 to 0.3 parts by weight based on 100 parts by weight of the ethylene-polar monomer copolymer.

Further, Patent Document 2 discloses a solar cell sealing film having an improved insulation property especially under high-temperature environments, which comprises ethylene-polar monomer copolymer such as EVA and cross-linkers, and has volume resistivity in the range of 1.0× 10¹³ to 5.0×10¹⁴ Ω·cm. In Patent Document 2, compositions and contents of cross-linker and cross-linking auxiliary agent are regulated in order to obtain a solar cell sealing film having the above volume resistivity.

### Patent Document

### Prior Art Documents

Patent Document 1: JP 2006-036875 A
Patent Document 2: JP 2008-205448 A

### Summary of the Invention

### Problem to be solved by the Invention

However, depending on a type and/or an installation location of a solar cell, a solar cell sealing film is occasionally required to have more improved insulation properties, so developments of the sealing film having higher insulation properties are desired. In this case, the sealing film is also required to have durability of adhesive properties so as to maintain an insulation property for a long term period under high-temperature environments.

It is therefore an object of the present invention to provide a solar cell sealing film which has improved insulation properties and durability of adhesive properties under high-temperature environments.

Furthermore, an object of the present invention is to provide a solar cell using the sealing film.

### Means for Solving Problem

The inventors of the present invention have found that the above object can be attained by using a combination of specific types of silane-coupling agents.

In other words, the above object can be attained by a solar cell sealing film consisting of a composition comprising ethylene-polar monomer copolymer and a cross-linker, wherein the composition further contains silane-coupling agent A and silane-coupling agent B, the silane-coupling A having three alkoxysilyl groups in its molecule, and the silane-coupling agent B having one alkoxysilyl group in its molecule.

The silane-coupling agent A has a structure in formed by combining three alkoxysilyl groups with an organic functional group. Further, the silane-coupling agent B has a structure formed by combining one alkoxysilyl group with an organic functional group. The use of the composition containing those two types of silane-coupling agents brings about a solar cell sealing film having an improved insulation property and durability of an adhesive property under high-temperature environments, compared to a conventional sealing film.

Preferred embodiments of the solar cell sealing film according to the present invention are described as follows:
(1) the silane-coupling agent A is contained in the range of 0.2 to 1 part by mass based on 100 parts by mass of the ethylene-polar monomer copolymer, and the silane-coupling agent B is contaned in the range of 0.1 to 1 part by mass based on 100 parts by mass of the ethylene-polar monomer copolymer. The use of the composition containing those two types of the silane-coupling agents in the above content ranges brings about more sufficient insulation properties and durability of adhesive properties of the sealing film.
(2) The silane-coupling agent A has an isocyanurate group in its molecule. In other words, it is preferred that the silane-coupling agent A has a structure formed by combining three alkoxysilyl groups with an isocyanurate group.
(3) The silane-coupling agent A is represented by the following formula (I): 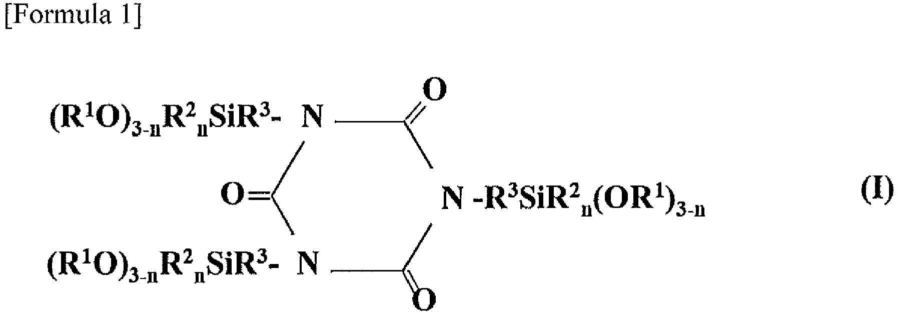 in which R¹s and R²s each independently represent a methyl group, an ethyl group or a 2-methoxyethyl group, R³s each independently represent a bivalent hydrocarbon group having 2 to 11 carbon atoms, and "n" represents 0, 1 or 2.
(4) The silane-coupling agent A is at least one selected from the group consisting of 1,3,5-tris[3-(trimethoxysilyl)propyl]isocyanurate, 1,3,5-tris [3-(triethoxysilyl)propyl]isocyanurate, 1,3,5-tris[3-(methyldimethoxysilyl)propyl]isocyanurate, and 1,3,5-tris[3-(methyldiethoxysilyl)propyl]isocyanurate. Of these compounds, 1,3,5-tris[3-(trimethoxysilyl)propyl]isocyanurate is particularly preferred.
(5) The silane-coupling agent B is represented by the following formula (II):

   [Formula 2]

   **(R⁴O)₃₋ₘR⁵ₘSi-X** (**II**)

   in which R⁴ and R⁵ each independently represent a methyl group, an ethyl group or a 2-methoxyethyl group, X represents an organic functional group having as a terminal group a vinyl group, an epoxy group, a styryl group, a methacryloyl group, an acryloyl group, an amino group, a mercapto group or an isocyanate group, of which each may have a substituent, and "m" represents 0 or 1.
(6) The silane-coupling agent B is at least one selected from the group consisting of 3-methacryloxypropyltrimethoxysilane, 3-methacryloxypropyltriethoxysilane, N-phenyl-3-aminopropyltrimethoxysilane, and 3-isocyanatopropyltriethoxysilane.
(7) The solar cell sealing film has a volume resistivity after cross-linkage of 1.0×10¹⁶Ω·cm or more, which is determined in an atmosphere of 25°C. A sealing film having the above-mentioned volume resistivity shows a sufficiently high insulation property.
(8) The solar cell sealing film has a glass adhesive strength of 20N/cm or more, the strength being measured according to 180° peel test (JIS K 6584, 1994), after the sealing film is cross-linked and subsequently left at temperature of 85°C and humidity of 85%RH for 2000 hours. A sealing film having the above-mentioned glass adhesive strength after the endurance test shows a sufficient durability of adhesive property.
(9) The ethylene-polar monomer copolymer is ethylene-vinyl acetate copolymer.
(10) The cross-linker is an organic peroxide.

Furthermore, the above object is attained by a solar cell obtained by sealing photovoltaic elements in the solar cell sealing film(s) of the present invention, which has enhanced power generation efficiency and maintains the power generation efficiency under high-temperature environments for a long term period.

### Advantageous Effects of the Invention

According to the present invention, the solar cell sealing film comprising chiefly ethylene-polar monomer copolymer comprises a combination of specific types of silane-coupling agents, whereby a solar cell sealing film of the invention has an improved insulation property and durability of an adhesive property under high-temperature environments.

Therefore, the use of the solar cell sealing film of present invention makes it possible to provide a solar cell which has enhanced power generation efficiency and maintains the high power generation efficiency under high-temperature environments for a long term period.

### Brief Description of the Drawings

[Fig. 1] Fig. 1 is a schematic section view of a conventional solar cell.
[Fig. 2] Fig. 2 is a diagram for explaining 180° peel test in order to evaluate adhesive strength.

### Description of Embodiments

A solar cell sealing film of the present invention consists of a composition comprising at least ethylene-polar monomer copolymer and a cross-linker. Further, the composition contains silane-coupling agent A and silane-coupling agent B, the silane-coupling A having three alkoxysilyl groups in its molecule, and the silane-coupling agent B having one alkoxysilyl group in its molecule. The silane-coupling agent A has a structure formed by combining three alkoxysilyl groups with an organic functional group. Further, the silane-coupling agent B has a structure formed by combining one alkoxysilyl group with an organic functional group (i.e., the silane-coupling agent B is a conventional silane-coupling agent used as an adhesion improver). The use of the composition containing those two types of silane-coupling agents brings about a solar cell sealing film having an improved an insulation property and durability of an adhesive property under high-temperature environments, compared to the case of using either one of the two, as described in Examples hereinbelow.

In the invention, the contents of the silane-coupling agent A and the silane-coupling agent B in the composition are not particularly restricted. However, use of a small amount of the silane-coupling agent A and the silane-coupling agent B occasionally leads to the lowered effects of the invention. By contrast, use of an excessive amount of the silane-coupling agents occasionally leads to bleeding out, the bleeding-out meaning additives leaching after a film forming. Therefore, the content of the silane-coupling agent A is preferably in the range of 0.2 to 1 part by mass, more preferably in the range of 0.2 to 0.8 part by mass, particularly in the range of 0.2 to 0.5 part by mass based on 100 parts by mass of the ethylene-polar monomer copolymer. Further, the content of the silane-coupling agent B is preferably in the range of 0.1 to 1 part by mass, more preferably in the range of 0.1 to 0.8 part by mass, particularly in the range of 0.3 to 0.8 part bu mass based on 100 parts by mass of the ethylene-polar monomer copolymer. Hence, it is possible to obtain a solar cell sealing film having more sufficient insulation properties and durability of adhesive properties without a defect on the film forming.

In the invention, any silane-coupling agents having three alkoxysilyl groups in its molecule can be employed as the silane-coupling agent A. Examples include a compound formed by combining theree alkoxysilyl groups with a multifunctional organic functional group, and a compound obtained by trimerization of a compound formed by combining one alkoxysilyl group with an organic functional group. The silane-coupling agent A preferably has a structure having an isocyanurate group in its molecule.

The silane-coupling agent A is preferably represented by the following formula (I): 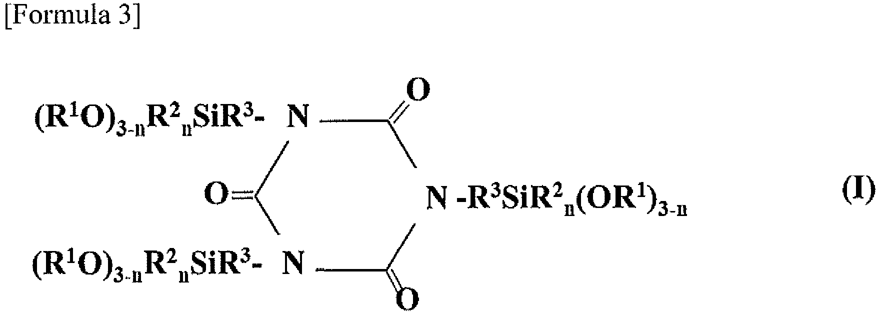 in which R¹s and R²s each independently represent a methyl group, an ethyl group or a 2-methoxyethyl group, R³s each independently represent a bivalent hydrocarbon group having 2 to 11 carbon atoms, and "n" represents 0, 1 or 2. Examples of the bivalent hydrocarbon group having 2 to 11 carbon atoms include an alkylene group such as an ethylene group, a propylene group, a hexylene group, a n-octylene group and an iso-decylene group, an arylene group such as a phenylene group and a propyl phenylene group, and an aralkylene group such as a phenyl propylene group, a phenyl butylene group, a phenyl hexylene group.

Preferable examples of the silane-coupling agent include 1,3,5-tris[3-(trimethoxysilyl)propyl]isocyanurate,
1,3,5-tris[3-(triethoxysilyl)propyl]isocyanurate,
1,3,5-tris[3-(methyldimethoxysilyl)propyl]isocyanurate, and 1,3,5-tris[3-(methyldiethoxysilyl)propyl]isocyanurate. These silane-coupling agents can be used as the silane-coupling agent A singly or in combination of two or more kinds. From the viewpoint of a glass adhesive property, 1,3,5-tris[3-(trimethoxysilyl)propyl]isocyanurate and 1,3,5-tris[3-(triethoxysilyl)propyl]isocyanurate, are more preferred. Further, from the viewpoint of ready availability, 1,3,5-tris[3-(trimethoxysilyl)propyl]isocyanurate is particularly preferred.

On the other hand, in the invention, any silane-coupling agents having a structure formed by combining one alkoxysilyl group with an organic functional group can be employed as the silane-coupling agent B. Further, the silane-coupling agent B is preferably represented by the following formula (II):

[Formula 4]

**(R⁴O)₃₋ₘR⁵ₘSi-X** (**II**)

in which R⁴ and R⁵ each independently represent a methyl group, an ethyl group or a 2-methoxyethyl group, X represents an organic functional group having as a terminal group a vinyl group, an epoxy group, a styryl group, a methacryloyl group, an acryloyl group, an amino group, a mercapto group or an isocyanate group, of which each may have a substituent, and "m" represents 0 or 1 ("m" is preferably 0). Here, the X may represent a group which the above functional group is combined with Si directly, or via a bivalent hydrocarbon group such as an alkylene group. Examples of the X include a vinyl group, a 3-glycidoxypropyl group, a p-styryl group, a 3-methacryloxypropyl group, a 3-acryloylpropyl group, a 3-aminopropyl group, an N-phenyl-3-aminopropyl group, and a 3-mercaptopropyl group, a 3-isocyanatepropyl group.

The silane-coupling agent represented by the formula (II) is conventionally used as an adhesion improver. Examples include 3-methacryloxypropyltrimethoxysilane,
3-methacryloxypropyltriethoxysilane,
3-methacryloxypropylmethyldimethoxysilane,
3-methacryloxypropylmethyldiethoxysilane, vinytrimethoxysilane, vinyltriethoxysilane, vinyltris(2-methoxyethoxy)silane, vinyltriacetoxysilane, 3-glycidoxypropyltrimethoxysilane, 3-glycidoxypropylmethyldimethoxysilane,
3-glycidoxypropyltriethoxysilane,
2-(3,4-epoxycyclohexyl)ethyltrimethoxysilane,
3-mercaptopropyltrimethoxysilane, 3-aminopropyltriethoxysilane, N-2-(aminoethyl)-3-aminopropyltrimethoxysilane,
N-phenyl-3-aminopropyltrimethoxysilane, and 3-isocyanatepropyltriethoxysilane.

These silane-coupling agents can be used as the silane-coupling agent B singly or in combination of two or more kinds. From the viewpoint of a glass adhesive property, silane-coupling agents having a trialkoxysilyl group are preferred. Preferable examples include 3-methacryloxypropyltrimethoxysilane,
3-methacryloxypropyltriethoxysilane,
N-phenyl-3-aminopropyltrimethoxysilane, and 3-isocyanatepropyltriethoxysilane. Particularly preferred is 3-methacryloxypropyltrimethoxysilane because of obtaining more enhanced glass adhesive strength.

In the invention, the solar cell sealing film preferably has a volume resistivity after cross-linkage of 1.0×10¹⁶Ω·cm or more, which is determined in an atmosphere of 25°C, as an evaluation of an insulation property. A sealing film having the above-mentioned volume resistivity shows a sufficiently high insulation property, compared to a conventional sealing film.

In the invention, volume resistivity after cross-linkage is value measured by using a high resistivity meter (Hiresta UP available from Mitsubishi Chemical Corporation) with a probe (UR-100 available from Mitsubishi Chemical Corporation) in an atmosphere of 25°C, after solar cell sealing film is cross-linked.

Further, in the invention, the solar cell sealing film preferably has a glass adhesive strength of 20N/cm or more, the strength being measured according to 180° peel test (JIS K 6584, 1994), after the sealing film is cross-linked and subsequently left at temperature of 85°C and humidity of 85%RH for 2000 hours, as an evaluation of durability of an adhesive property. A sealing film having the above-mentioned glass adhesive strength after the endurance test shows a sufficient durability of adhesive property.

The solar cell sealing film of the invention is explained in detail below.

### [Ethylene-polar monomer copolymer]

In the invention, examples of polar monomer of the ethylene-polar monomer copolymer include unsaturated carboxylic acids, salts thereof, esters thereof and amides thereof, vinyl esters and carbon monoxide. Concretely, examples of the polar monomer include unsaturated carboxylic acids such as acrylic acid, methacrylic acid, fumaric acid, itaconic acid, monomethyl maleate, monoethyl maleate, maleic anhydride and itaconic anhydride, monovalent metal salts (e.g., lithium, sodium or potassium) of these unsaturated carboxylic acids, and multivalent metal salts (e.g., magnesium, calcium or zinc) of these unsaturated carboxylic acids; unsaturated carboxylic acid esters such as methyl acrylate, ethyl acrylate, isopropyl acrylate, isobutyl acrylate, n-butyl acrylate, isooctyl acrylate, methyl methacrylate, ethyl methacrylate, isobutyl methacrylate and dimethyl maleate; vinyl esters such as vinyl acetate and vinyl propionate; carbon monoxide; and sulfur dioxide. The monomers can be used singly or in combination of two or more kinds.

Examples of the ethylene-polar monomer copolymer include ethylene-unsaturated carboxylic acid copolymers such as ethylene-acrylic acid copolymer and ethylene-methacrylic acid copolymer; ionomers obtained by neutralizing a part or whole of carboxylic acids of ethylene-unsaturated carboxylic acids copolymer by the above-mentioned metals; ethylene-unsaturated carboxylic acid ester copolymers such as ethylene-methyl acrylate copolymer, ethylene-ethyl acrylate copolymer, ethylene-methyl methacrylate copolymer, ethylene-isobutyl acrylate copolymer and ethylene-n-butyl acrylate copolymer; ethylene-unsaturated carboxylic acid ester-unsaturated carboxylic acid copolymers such as ethylene-isobutyl acrylate-methacrylic acid copolymer, ethylene-n-butyl acrylate-methacrylic acid copolymer; ionomers obtained by neutralizing a part or whole of carboxylic acids of ethylene-unsaturated carboxylic acid ester-unsaturated carboxylic acid copolymers by the above-mentioned metals; and ethylene-vinyl ester copolymer such as ethylene-vinyl acetate copolymer.

The ethylene-polar monomer copolymer used in the invention preferably has Melt Flow Rate (according to JIS K 7210) of 35g/10min or less, especially 3 to 6g/10min. Use of the ethylene-polar monomer copolymer having Melt Flow Rate of the above-mentioned range enables to repress the phenomenon that the sealing film melts and go off the defined location to protrude outside the substrate when the film is heated under pressure in a sealing step for preparation of solar cell.

A value of Melt Flow Rate (MFR) is determined under the conditions of temperature of 190°C and load of 21.18N according to JIS K 7210.

The ethylene-polar monomer copolymer is most preferably ethylene-vinyl acetate copolymer (EVA), whereby a solar cell sealing film having low cost and excellent transparency and flexibility can be obtained.

In the EVA, the content of vinyl acetate recurring unit generally is in the range of 20 to 35% by mass, preferably 22 to 30% by mass, especially 24 to 28% by mass based on 100 parts by mass of EVA. The less content of vinyl acetate, the harder EVA composition is obtained. When the content is less than 20% by mass, the sealing film cross-linked and cured at high temperature does not occasionally show sufficiently high transparency. On the other hand, when the content is more than 35% by mass, the sealing film is apt to have insufficient hardness.

The solar cell sealing film of the invention may collaterally contain polyvinyl acetal resin (e.g., polyvinyl formal, polyvinyl butyral (PVB resin), modified PVB) or vinyl chloride resin, in addition to ethylene-polar monomer copolymer. In that case PVB is particularly preferred.

### [Cross-linker]

The cross-linker contained in the composition of the solar cell sealing film of the invention enables the formation of the cross-linked structure of ethylene-vinyl acetate copolymer, thereby improving strength, adhesive properties and durability of the film. An organic peroxide or photopolymerization initiator is preferably used as the cross-linker. The organic peroxide is more preferably used because the resultant sealing film is improved in temperature dependencies in adhesion, transparency, humidity resistance and penetration resistance.

Any organic peroxides that can be decomposed at a temperature of not less than 100°C to generate radical(s) can be employed as the above-mentioned organic peroxide. The organic peroxide is generally selected in the consideration of film-forming temperature, conditions for preparing the composition, curing (bonding) temperature, heat resistance of body to be bonded, storage stability. Particularly preferred is a material having a decomposition temperature of not less than 70°C in a half-life of 10 hours.

From the viewpoint of resin processing temperature and storage stability, examples of the organic peroxides include benzoylperoxide-type cure agents, tert-hexylperoxypivalate, teut-butylperoxypivalate, 3,5,5-trimethylhexanoylperoxide, di-n-octanoylperoxide, lauroylperoxide, stearoylperoxide, 1,1,3,3-tetramethylbutylperoxy-2-ethylhexanoate, succinic acid peroxide, 2,5-dimethyl-2,5-di(tert-butylperoxy)hexane, 2,5-dimethyl-2,5-di(2-ethylhexanoylperoxy)hexane,
1-cyclohexyl-1-methylethylperoxy-2-ethylhexanoate,
tert-hexylperoxy-2-ethylhexanoate, 4-methylbenzoylperoxide, tert-butylperoxy-2-ethylhexanoate, m-toluoyl+benzoylperoxide, benzoylperoxide, 1,1-bis(tert-butylperoxy)-3,3,5-trimethylcyclohexane, 1,1 -bis(tert-butylperoxy)cyclohexane,
1,1-bis(tert-hexylperoxy)-3,3,5-trimethylcyclohexane,
2,2-bis(4,4-di-tert-butylperoxycyclohexyl)propane,
1,1-bis(tent-butylperoxy)cyclododecane,
tert-hexylperoxyisopropylmonocarbonate, tert-butylperoxy maleic acid, tert-butylperoxy-3,5,5 -trimethylhexanoate, tert-butylperoxylaurate, 2,5-dimethyl-2,5-di(methylbenzoylperoxy)hexane,
tert-butylperoxyisopropylmonocarbanate,
tert-butylperoxy-2-ethylhexylmonocarbonate, tert-hexylperoxybenzoate, and 2,5-dimethyl-2,5-di(benzoylperoxy)hexane.

As the benzoylperoxide-type cure agents, any organic peroxides that can be decomposed at a temperature of not less than 70°C to generate radical(s) can be employed. It is preferable to use a material having a decomposition temperature of not less than 50°C in a half-life of 10 hours. The benzoyl peroxide-type cure agents are selected in the consideration of conditions for preparing the composition, film-forming temperature, curing (bonding) temperature, heat resistance of body to be bonded, storage stability. Examples of the benzoyl peroxide-type cure agents include benzoylperoxide, 2,5-dimethylhexyl-2,5-bisperoxybenzoate, p-chlorobenzoylperoxide, m-toluoylperoxide, 2,4-dichlorobenzoylperoxide, tert-butylperoxybenzoate. The benzoyl peroxide-type cure agents can be employed singly or in combination of two or more kinds.

As the organic peroxide, 2,5-dimethyl-2,5-di(tert-butylperoxy)hexane and 1.1-bis(tert-hexylperoxy)-3,3,5-trimethylcyclohexane are particularly preferred. These organic peroxides bring about a solar cell sealing film having a superior insulation property.

The content of the organic peroxide in the sealing film is preferably in the range of 0.1 to 2.0 parts by mass, more preferably in the range of 0.2 to 1.5 parts by mass based on 100 parts by mass of an ethylene-polar monomer copolymer. When the content of the organic peroxide is less, the insulation property of the resultant sealing film is apt to be decreased. When the content of the organic peroxide is excessive, the compatibility of the organic peroxide with the ethylene-polar monomer copolymer is apt to be decreased.

Any known photopolymerization initiators can be employed as the crosslinker. Preferred are initiators having high storage stability after addition thereof. Examples of the photopolymerization initiators include acetophenone type initiators such as 2-hydroxy-2-methyl-1-phenylpropane-1-on,
1-hydroxycyclohexylphenylketone, and 2-methyl-1-[4-(methylthio)phenyl]-2-morphorino-propane-1-on; benzoin type initiators such as benzildimethylketal; benzophenone type initiators such as benzophenone, 4-phenylbenzophenone and hydroxybenzophenone; and thioxanthone type initiators such as isopropylthioxanthone and 2,4-diethylthioxanthone. Further, as special type, there can be mentioned methylphenylglyoxylate. Especially preferred are 2-hydroxy-2-methyl-1-phenylpropane-1-on,
1-hydroxycyclohexylphenylketone,
2-methyl-1-[4-(methylthio)phenyl]-2-morphorino-propane-1-on and benzophenone. These photopolymerization initiators can be employed, if necessary, together with one or more kinds of a photopolymerization promoter such as a benzoic acid type compound (e.g., 4-dimethylaminobenzoic acid) or a tertiary amine compound by mixing the initiator with the promoter in optional ratio. The initiator can be singly or in combination of two or more kinds.

The photopolymerization initiator is preferably contained in the range of 0.5 to 5.0 parts by mass based on 100 parts by mass of ethylene-polar monomer copolymer.

### [Cross-linking auxiliary agent]

The solar cell sealing film of the present invention may contain cross-linking auxiliary agent if necessary. The cross-linking auxiliary agent enables increase of gel fraction of ethylene-polar monomer copolymer and improvement of adhesive properties and durability of the sealing film.

The cross-linking auxiliary agent is generally used in an amount of 10 parts by mass or less, preferably in the range of 0.1 to 5.0 parts by mass, more preferably in the range of 0.1 to 2.5 parts by mass based on 100 parts by mass of ethylene-polar monomer copolymer. Accordingly, a sealing film having an excellent adhesive property can be obtained.

Examples of the cross-linking auxiliary agents (compounds having radical polymerizable groups as functional group) include tri-functional cross-linking auxiliary agents such as triallyl cyanurate and triallyl isocyanurate, and mono- or bi-functional cross-linking auxiliary agents of (meth)acryl esters (e.g., NK Ester, etc.). Of these compounds, triallyl cyanurate and triallyl isocyanurate are preferred, especially triallyl isocyanurate.

### [Others]

The sealing film of the invention can further contain, if necessary, various additives such as plasticizers, acryloxy group-containing compounds, methacryloxy group-containing compounds, and/or epoxy group-containing compounds, for improvement or adjustment of various properties of the resultant film (e.g., mechanical strength, optical characteristics such as transparency, heat-resistance, light-resistance, or crosslinking rate, etc.).

Generally, polybasic acid esters and polyhydric alcohol esters can be used as the plasticizer, although there are not particular restrictions to plasticizer to be used. Examples of the plasticizers include dioctylphthalate, dihexyladipate, triethyleneglycol-di-2-ethylbutyrate, butylsebacate, tetraethyleneglycoldiheptanoate and triethyleneglycoldipelargonate. The plasticizers can be used singly, or in combination of two or more kinds. The plasticizer is preferably contained in amount of not more than 5 parts by mass based on 100 parts by mass of ethylene-polar monomer copolymer.

Generally, derivatives of acrylic acid or methacrylic acid such as esters and amides of acrylic acid or methacrylic acid can be used as the acryloxy group-containing compound and methacryloxy group-containing compound. Examples of the ester residue include linear alkyl groups (e.g., methyl, ethyl, dodecyl, stearyl and lauryl), cyclohexyl group, tetrahydrofurfuryl group, aminoethyl group, 2-hydroxyethyl group, 3-hydroxypropyl group, 3-chloro-2-hydroxypropyl group. Example of the amide includes diacetone acryl amide. Further, examples of the esters include esters of acrylic acid or methacrylic acid with polyhydric alcohol such as ethyleneglycol, triethyleneglycol, polypropyleneglycol, polyethyleneglycol, trimethylolpropane or pentaerythritol.

Examples of the epoxy group-containing compounds include triglycidyltris(2-hydroxyethyl)isocyanurate, neopentylglycoldiglycidylether, 1,6-hexanedioldiglycidylether, allylglycidylether, 2-ethylhexylglycidylether, phenylglycidylether, phenol(ethyleneoxy)₅glycidylether, p-tert-butylphenylglycidylether, diglycidyladipate, diglycidylphthalate, glycidylmethacrylate and butylglycidylether.

The content of the acryloxy group-containing compounds, the methacryloxy group-containing compounds or the epoxy group-containing compounds is preferably in the range of 0.5 to 5.0 parts by mass, particularly in the range of 1.0 to 4.0 parts by mass based on 100 parts by mass of ethylene-polar monomer copolymer.

Furthermore, the sealing film may further contain ultraviolet absorbent, light stabilizer and antioxidant. The use of ultraviolet absorbent suppresses deterioration of ethylene-polar monomer copolymer by irradiation of light whereby a solar cell sealing film suffers from yellowing. Examples of the ultraviolet absorbent, though are not particularly restricted, preferably include benzophenone-type ultraviolet absorbents such as 2-hydroxy-4-methoxybenzophenone, 2-hydroxy-4-n-dodecyloxybenzophenone, 2,4-dihydroxybenzophenone, 2,2'-dihydroxy-4-methoxybenzophenone and 2-hydroxy-4-n-octoxybenzophenone. The content of the benzophenone-type ultraviolet absorbent is preferably in the range of 0.01 to 5 parts by mass based on 100 parts by mass of ethylene-polar monomer copolymer.

The use of the light stabilizer also suppresses deterioration of ethylene-polar monomer copolymer by irradiation of light whereby a solar cell sealing film suffers from yellowing. A so-called hindered amine light stabilizer can be preferably used as the light stabilizer. Examples of the light stabilizer include LA-52, LA-57, LA-62, LA-63, LA-63p, LA-67 and LA-68 (each manufactured by ADEKA Co., Ltd.), Tinuvin 744, Tinuvin 770, Tinuvin 765, Tinuvin 144, Tinuvin 622LD and CHIMASSORB 944LD (each manufactured by Ciba Specialty Chemicals Co., Ltd.), and UV-3034 (manufactured by B. F. Goodrich). The light stabilizers can be each used singly, or in combination of two or more kinds. The content of the light stabilizer is preferably in the range of 0.01 to 5 parts by mass based on 100 parts by mass of ethylene-polar monomer copolymer.

Examples of the antioxidants include hindered phenol-type antioxidants such as N,N'-hexan-1,6-diyl-bis[3-(3,5-di-tert-butyl-4-hydroxyphenyl)propionamid e], phosphorus-type heat stabilizers, lactone-type heat stabilizers, vitamin E-type heat stabilizers and sulfur-type heat stabilizers.

### [Preparation of solar cell sealing film]

The solar cell sealing film of the invention can be prepared in accordance with heretofore known processes. For example, the sealing film can be prepared by molding a composition including the above-discussed materials into a sheet-shaped product by extrusion molding or calendar molding (calendaring). Otherwise, the composition is dissolved in a solvent, the thus obtained solution is applied to an appropriate support by an appropriate coater, and then the applied solution is dried to form a coated film. Thus, a sheet-shaped product can be prepared. Additionally, the heating temperature at the film-formation is preferably a temperature that the cross-linker cause no reaction or little reactions. For instance, the temperature is preferably in the range of 40 to 90°C, particularly in the range of 40 to 80°C. The thickness of the solar cell sealing film, though is not particularly restricted, preferably is in the range of 50µm to 2mm.

### [Solar cell]

The structure of the solar cell of the invention is not particularly restricted, as long as the solar cell obtained by sealing photovoltaic elements (including photovoltaic elements and thin-film photovoltaic elements) in the solar cell sealing film(s) of the invention. Examples of the structure include a structure that photovoltaic elements are sealed through the solar cell sealing films between a transparent front side protection material and a backside protection material. In the invention, "front side" corresponds to a side of the photovoltaic element irradiated with the light (light-receiving side), whereas "backside" corresponds to the reverse side of the light-receiving side of the photovoltaic elements.

As described above, the solar cell sealing film of the invention has an improved insulation property and durability of an adhesive property under high-temperature environments. Therefore, the solar cell of the invention has enhanced power generation efficiency because of less occurrence of a leakage of electricity, and maintains the high power generation efficiency under high-temperature environments for a long term period.

For producing the solar cell of the invention, for instance, a transparent front side protection material 11, a front side sealing film 13A, photovoltaic elements 14, a backside sealing film 13B and a backside protection material 12 can be laminated in this order, as shown in Fig. 1. Thereafter, the sealing films 13A and 13B can be cross-linked or cured according to a conventional process such as the application of heating and pressure. For example, the laminated body can be bonded under the application of heating and pressure by using a vacuum laminator in the conditions of temperature of 135 to 180°C, preferably 140 to 180°C, especially 155 to 180°C, degassing time period of 0.1 to 5min, pressing pressure of 0.1 to 1.5kg/cm² and pressing time period of 5 to 15min. This heating and pressure enables the cross-linking of the ethylene-polar monomer copolymer contained in the front side sealing film 13A and the backside sealing film 13B, whereby the transparent front side protection material 11, the backside protection material 12 and the photovoltaic elements 14 are combined through the front side sealing film 13A and the backside sealing film 13B, which results in seal of the photovoltaic elements 14.

In addition, the solar cell sealing film of the invention can be used for not only a solar cell using single-crystalline or polycrystalline silicone crystal type photovoltaic elements as shown in Fig. 1, but also thin-film solar cells, such as thin-film silicon type solar cell, an amorphous silicon film type solar cell and copper indium selenide (CIS) type solar cell. Examples of a structure of thin-film solar cell include;
a structure that on a thin-film photovoltaic element formed on surface of a transparent front side protection material such as a glass substrate, a polyimide substrate and a fluorine resin type transparent substrate by chemical vapor deposition method, etc., the solar cell sealing film of the invention and a backside protection material are superposed and adhesively combined,
a structure that on a thin-film photovoltaic element formed on a surface of a backside protection material, the solar cell sealing film of the invention and a transparent front side protection material are superposed and adhesively combined, and
a structure that a transparent front side protection material, a front side solar cell sealing film, a thin-film photovoltaic element, a backside solar cell sealing film and a backside protection material are laminated in this order, and adhesively combined.

The transparent front side protection material 11 used in the solar cell of the invention is preferably a glass substrate such as silicate glass. The thickness of the glass substrate is generally in the range of 0.1 to 10mm, preferably 0.3 to 5mm. The glass substrate can be chemically or thermally tempered.

The backside protection material 12 for use in the invention is preferably a plastic film such as polyethylene terephthalate (PET). From the viewpoint of heat resistance and moisture resistance, a fluorinated polyethylene film or especially a film having structure of fluorinated polyethylene film/Al/ fluorinated polyethylene film laminated in this order is also preferred.

The solar cell (including thin-film solar cell) of the invention is characterized by the specific sealing films used as the front side and/or the backside sealing film as described above. Therefore, there is no particular restriction on the materials of the solar cell except for the sealing films (i.e., transparent front side protection material, backside protection material, photovoltaic elements, etc.). Those materials can have the same structures/compositions as those in heretofore known solar cells.

### Examples

The invention is illustrated in detail using the following Examples.

### [Examples 1 to 17, Comparative Examples 1 to 7]

Materials of the formulation set forth in Table 1 and Table 2 were fed to a roll mill, and kneaded at 70°C to prepare a composition for a solar cell sealing film. The composition for a solar cell sealing film was formed by calendaring processing at temperature of 70°C and cooled to prepare a solar cell sealing film (thickness: 0.5mm).

### [Evaluation methods]

### (1) Volume resistivity

The resultant solar cell sealing film (having a size of 100mm× 100mm) was superposed on a releasable PET film (thickness: 0.75mm), temporarily bonded under application of pressure by using a vacuum laminator at 100°C for 1 minute, and then heated at 155°C for 45 minutes in an oven to be cross-linked.

Volume resistivity (Ω·cm) of each of the resultant samples was measured by using a high resistivity meter (Hiresta UP available from Mitsubishi Chemical Corporation) with a probe (UR-100 available from Mitsubishi Chemical Corporation) at an applied voltage of 1000V in an atmosphere of 25°C. A sample having a value of volume resistivity of 1.0×10¹⁶Ω·cm or more was regarded as acceptance.

### (2) Durability of glass adhesive strength

The adhesive strengths of the sealing films were evaluated according to 180° peel test (JIS K 6584, 1994). 180° peel test was carried out in the following procedures as shown in Fig. 2.

A glass substrate 21 (float glass: thickness; 3mm), the solar cell sealing film 23 and a releasable PET film (thickness: 0.75mm) were laminated in this order. The resultant laminate was subjected to vacuum degassing by using a vacuum laminator and preliminary pressure bonding treatment at a temperature of 100°C, for 10 minutes. Subsequently, the laminate was brought into an oven, and treated by application of pressure and heat at a temperature of 155°C for 45 minutes to be cross-linked. Then, the sealing film 23 was partially released from the glass substrate 21. The released part of the sealing film 23 was folded by 180° turn. By using a tensile tester (Autograph, manufactured by Shimadzu Co., LTD), peal strength at a tensile speed of 100mm/min was measured, as an initial glass adhesive strength (N/cm).

Further, in order to evaluate durability of the adhesive strength, the laminated sample prepared above was left at temperature of 85°C and humidity of 85%RH for 2000 hours. Thereafter glass adhesive strength (N/cm) after an endurance test of the sample was measured according to 180° peel test in the same manner as described above. A sample having a value of glass adhesive strength after an endurance test of 20N/cm or more was regarded as acceptance.

[Table 1]

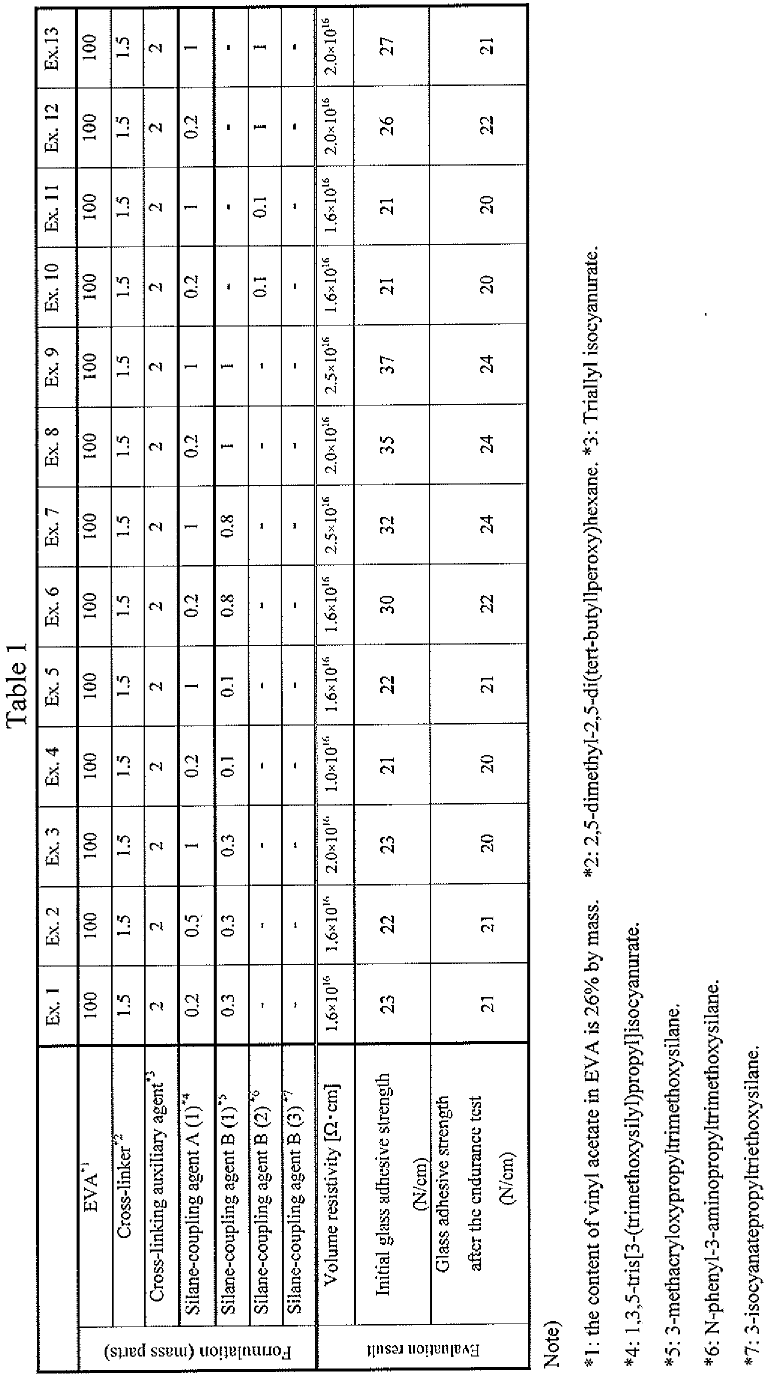

[Table 2]

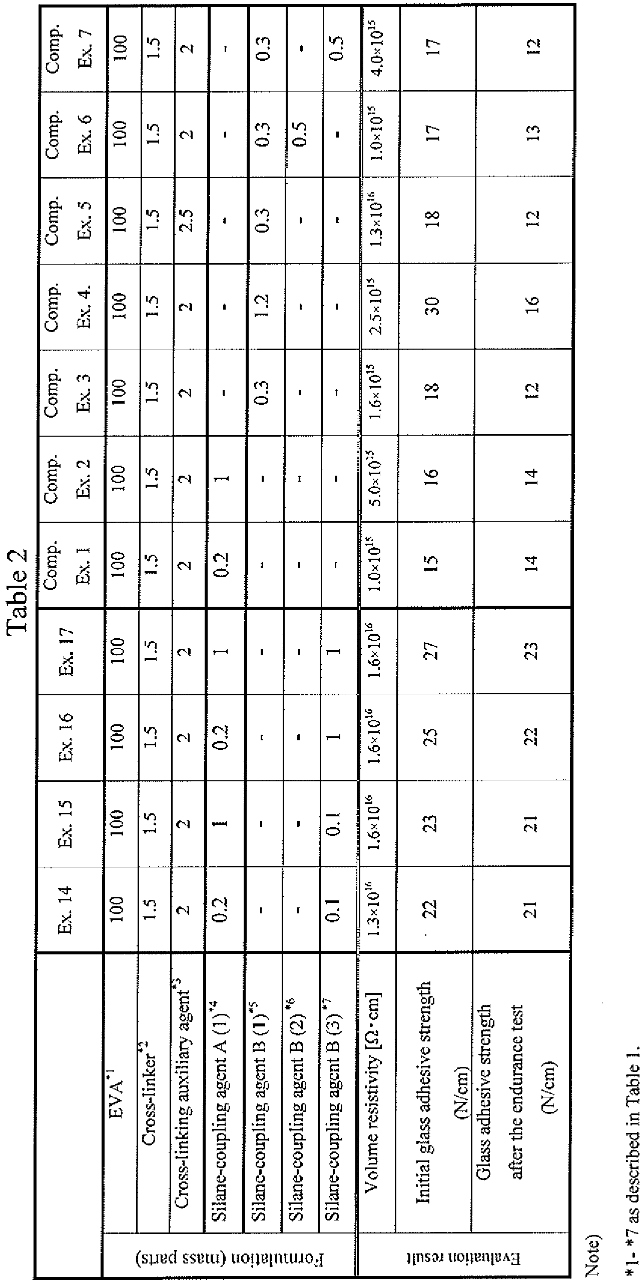

### [Evaluation result]

Evaluation results of each of the resultant samples are showed in Table 1 and Table 2. Solar cell sealing films containing 1,3,5-tris[3-(trimethoxysilyl)propyl]isocyanurate as silane-coupling A having three alkoxysilyl groups in the molecule, and 3-methacryloxypropyltrimethoxysilane, N-phenyl-3-aminopropyltrimethoxysilane, or 3-isocyanatepropyltriethoxysilane as silane-coupling agent B having one alkoxysilyl group in the molecule, which are described in Examples 1 to 17, are evaluated. As a result, the films of all Examples 1 to 17 are regarded as acceptance regarding the evaluations of volume resistivity in an atmosphere of 25°C and of durability of glass adhesive strength.

In contrast, the sealing films of Comparative Examples 1 and 2 containing only silane-coupling agent A do not show the improvement of the volume resistivity and the durability of glass adhesive strength. Further, the sealing films of Comparative Examples 3 and 4 containing only 3-methacryloxypropyltrimethoxysilane as silane-coupling agent B are not regarded as acceptance regarding the evaluations of the volume resistivity and durability of glass adhesive strength. The films of Comparative Example 5 comprising the silane-coupling agent in the same amount as Comparative Example 3, and triallyl isocyanurate as cross-linking auxiliary agent in a larger amount than it show improvement of volume resistivity, but non-acceptance regarding the evaluations of durability of glass adhesive strength. The cause of this result was considered to be because although the film comprising a large amount of cross-linking auxiliary agent is apt to be improved in volume resistivity because of improvement of cross-link density, the film tends to deteriorate due to its reduced flexibility.

The film of Comparative Example 6 comprising a combination of 3-methacryloxypropyltrimethoxysilane and N-phenyl-3-aminopropyltrimethoxysilane which belong to silane-coupling agent B, and the film of Comparative Example 7 comprising a combination of 3-methacryloxypropyltrimethoxysilane and 3-isocyanatepropyltriethoxysilane which belong to silane-coupling agent B do not show the improvement of the volume resistivity and of the durability of glass adhesive strength.

The above-mentioned results reveal that a solar cell sealing film of the invention has superior insulation properties including a volume resistivity after cross-linkage in an atmosphere of 25°C of 1.0×10¹⁶Ω·cm or more, and durability of glass adhesive strength under high-temperature environments.

The present invention is not restricted to the constitution of the Embodiments and the Examples as mentioned above and therefore can be varied widely within the gist of the invention.

### Industrial Applicability

The present invention makes it possible to provide a solar cell which has enhanced power generation efficiency and maintains the power generation efficiency under high-temperature environments for a long term period.

### Description of the reference numbers

- 11:: Transparent front side protection material
- 12:: Backside protection material
- 13A:: Front side sealing film
- 13B:: Backside sealing film
- 14:: Photovoltaic elements
- 21:: glass substrate
- 23:: solar cell sealing film

## Claims

1. A solar cell sealing film consisting of a composition comprising ethylene-polar monomer copolymer and a cross-linker,
wherein the composition further contains silane-coupling agent A and silane-coupling agent B,
the silane-coupling A having three alkoxysilyl groups in its molecule, and the silane-coupling agent B having one alkoxysilyl group in its molecule.

2. The solar cell sealing film as defined in claim 1, wherein the silane-coupling agent A is contained in the range of 0.2 to 1 part by mass based on 100 parts by mass of the ethylene-polar monomer copolymer, and the silane-coupling agent B is contaned in the range of 0.1 to 1 part by mass based on 100 parts by mass of the ethylene-polar monomer copolymer.

3. The solar cell sealing film as defined in claim 1 or 2, wherein the silane-coupling agent A has an isocyanurate group in its molecule.

4. The solar cell sealing film as defined in any of claims 1 to 3, wherein the silane-coupling agent A is represented by the following formula (I): 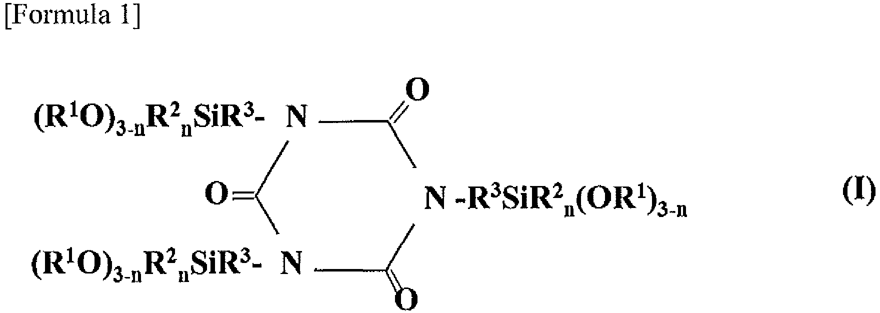 in which R¹s and R²s each independently represent a methyl group, an ethyl group or a 2-methoxyethyl group, R³s each independently represent a bivalent hydrocarbon group having 2 to 11 carbon atoms, and "n" represents 0, 1 or 2.

5. The solar cell sealing film as defined in any of claims 1 to 4, wherein the silane-coupling agent A is at least one selected from the group consisting of 1,3,5-tris[3-(trimethoxysilyl)propyl]isocyanurate, 1,3,5-tris[3-(triethoxysilyl)propyl]isocyanurate, 1,3,5-tris[3-(methyldimethoxysilyl)propyl]isocyanurate, and 1,3,5-tris[3-(methyldiethoxysilyl)propyl]isocyanurate.

6. The solar cell sealing film as defined in any of claims 1 to 5, wherein the silane-coupling agent B is represented by the following formula (II): [Formula 2]
**(R⁴O)₃₋ₘR⁵ₘSi-X** **(II)**
in which R⁴ and R⁵ each independently represent a methyl group, an ethyl group or a 2-methoxyethyl group, X represents an organic functional group having as a terminal group a vinyl group, an epoxy group, a styryl group, a methacryloyl group, an acryloyl group, an amino group, a mercapto group or an isocyanate group, of which each may have a substituent, and "m" represents 0 or 1.

7. The solar cell sealing film as defined in any of claims 1 to 6, wherein the silane-coupling agent B is at least one selected from the group consisting of 3-methacryloxypropyltrimethoxysilane, 3-methacryloxypropyltriethoxysilane, N-phenyl-3-aminopropyltrimethoxysilane, and 3-isocyanatopropyltriethoxysilane.

8. The solar cell sealing film as defined in any of claims 1 to 7, which has a volume resistivity after cross-linkage of 1.0×10¹⁶Ω·cm or more, which is determined in an atmosphere of 25°C

9. The solar cell sealing film as defined in any of claims 1 to 8, which has a glass adhesive strength of 20N/cm or more, the strength being measured according to 180° peel test (JIS K 6584, 1994), after the sealing film is cross-linked and subsequently left at temperature of 85°C and humidity of 85%RH for 2000 hours.

10. The solar cell sealing film as defined in any of claims 1 to 9, wherein the ethylene-polar monomer copolymer is ethylene-vinyl acetate copolymer.

11. The solar cell sealing film as defined in any of claims 1 to 10, wherein the cross-linker is an organic peroxide.

12. A solar cell obtained by sealing photovoltaic elements in the solar cell sealing film(s) as defined in any of claims 1 to 11.

## Patentansprüche

1. Solarzellenversiegelungsfilm bestehend aus einer Zusammensetzung umfassend ein Copolymer von Ethylen/polarem Monomer und ein Vernetzungsmittel,
wobei die Zusammensetzung ferner einen Silanhaftvermittler A und Silanhaftvermittler B enthält,
wobei der Silanhaftvermittler A drei Alkoxysilylgruppen in seinem Molekül aufweist und der Silanhaftvermittler B eine Alkoxysilylgruppe in seinem Molekül aufweist.

2. Solarzellenversiegelungsfilm wie in Anspruch 1 definiert, wobei der Silanhaftvermittler A in einer Menge im Bereich von 0,2 bis 1 Masseteil, auf 100 Masseteile des Copolymers von Ethylen/polarem Monomer bezogen, enthalten ist und der Silanhaftvermittler B in einer Menge im Bereich von 0,1 bis 1 Masseteil, auf 100 Masseteile des Copolymers von Ethylen/polarem Monomer bezogen, enthalten ist.

3. Solarzellenversiegelungsfilm wie in Anspruch 1 oder 2 definiert, wobei der Silanhaftvermittler A eine Isocyanuratgruppe in seinem Molekül aufweist.

4. Solarzellenversiegelungsfilm wie in einem der Ansprüche 1 bis 3 definiert, wobei der Silanhaftvermittler A durch die folgende Formel (I) dargestellt ist: 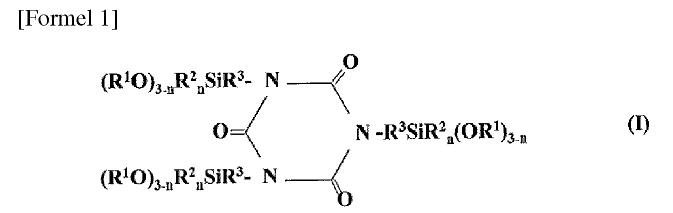 wobei die R¹ und R² jeweils unabhängig eine Methylgruppe, eine Ethylgruppe oder eine 2-Methoxyethylgruppe darstellen, die R³ jeweils unabhängig eine zweiwertige Kohlenwasserstoffgruppe darstellen, die 2 bis 11 Kohlenstoffatome aufweist, und "n" 0, 1 oder 2 darstellt.

5. Solarzellenversiegelungsfilm wie in einem der Ansprüche 1 bis 4 definiert, wobei der Silanhaftvermittler A mindestens eines ist ausgewählt aus der Gruppe bestehend aus 1,3,5-Tris[3-(trimethoxysilyl)propyl]isocyanurat, 1,3,5-Tris[3-(triethoxysilyl)propyl]isocyanurat, 1,3,5-Tris[3-(methyldimethoxysilyl )propyl]isocyanurat und 1,3,5-Tris[3-(methyldiethoxysilyl)propyl]isocyanurat.

6. Solarzellenversiegelungsfilm wie in einem der Ansprüche 1 bis 5 definiert, wobei der Silanhaftvermittler B durch die folgende Formel (II) dargestellt ist: [Formel 2]
**(R⁴O)₃₋ₘR⁵ₘSi-X** **(II)**
wobei R⁴ und R⁶ jeweils unabhängig eine Methylgruppe, eine Ethylgruppe oder eine 2-Methoxyethylgruppe darstellen, X eine organische funktionelle Gruppe darstellt, die als endständige Gruppe eine Vinylgruppe, eine Epoxygruppe, eine Styrylgruppe, eine Methacryloylgruppe, eine Acryloylgruppe, eine Aminogruppe, eine Mercaptogruppe oder eine Isocyanatgruppe aufweist, von denen jede einen Substituenten aufweisen kann und "m" 0 oder 1 darstellt.

7. Solarzellenversiegelungsfilm wie in einem der Ansprüche 1 bis 6 definiert, wobei der Silanhaftvermittler B mindestens eines ist ausgewählt aus der Gruppe bestehend aus 3-Methacryloxypropyltrimethoxysilan, 3-Methacryloxypropyltriethoxysilan, N-Phenyl-3-aminopropyltrimethoxysilan und 3-Isocyanatpropyltriethoxysilan.

8. Solarzellenversiegelungsfilm wie in einem der Ansprüche 1 bis 7 definiert, der einen spezifischen Volumenwiderstand nach dem Vernetzen von 1,0x10¹⁶Ω·cm oder mehr aufweist, der in einer Atmosphäre von 25 °C bestimmt wird.

9. Solarzellenversiegelungsfilm wie in einem der Ansprüche 1 bis 8 definiert, der eine Glashaftfestigkeit von 20 N/cm oder mehr aufweist, wobei die Festigkeit dem 180°-Schältest (JIS K 6584, 1994) entsprechend gemessen wird, nachdem der Versiegelungsfilm vernetzt und daraufhin bei einer Temperatur von 85 °C und einer Feuchte von 85 % RF 2000 Stunden lang gelassen worden ist.

10. Solarzellenversiegelungsfilm wie in einem der Ansprüche 1 bis 9 definiert, wobei das Copolymer von Ethylen/polarem Monomer Ethylen-Vinylacetat-Copolymer ist.

11. Solarzellenversiegelungsfilm wie in einem der Ansprüche 1 bis 10 definiert, wobei das Vernetzungsmittel ein organisches Peroxid ist.

12. Solarzelle, die durch Versiegeln photovoltaischer Elemente in dem/den Solarzellenversiegelungsfilm(en), wie in einem der Ansprüche 1 bis 11 definiert, erhalten wird.

## Revendications

1. Film d'étanchéité de pile photovoltaïque constitué d'une composition comprenant un copolymère d'éthylène-monomère polaire et un agent de réticulation,
dans lequel la composition contient en outre un agent de couplage au silane A et un agent de couplage au silane B,
l'agent de couplage au silane A ayant trois groupes alcoxysilyle dans sa molécule, et l'agent de couplage au silane B ayant un groupe alcoxysilyle dans sa molécule.

2. Film d'étanchéité de pile photovoltaïque tel que défini selon la revendication 1, dans lequel l'agent de couplage au silane A est contenu dans la plage de 0,2 à 1 partie en masse sur la base de 100 parties en masse du copolymère d'éthylène-monomère polaire, et l'agent de couplage au silane B est contenu dans la plage de 0,1 à 1 partie en masse sur la base de 100 parties en masse du copolymère d'éthylène-monomère polaire.

3. Film d'étanchéité de pile photovoltaïque tel que défini selon la revendication 1 ou 2, dans lequel l'agent de couplage au silane A possède un groupe isocyanurate dans sa molécule.

4. Film d'étanchéité de pile photovoltaïque tel que défini selon l'une quelconque des revendications 1 à 3, dans lequel l'agent de couplage au silane A est représenté par la formule suivante (I): 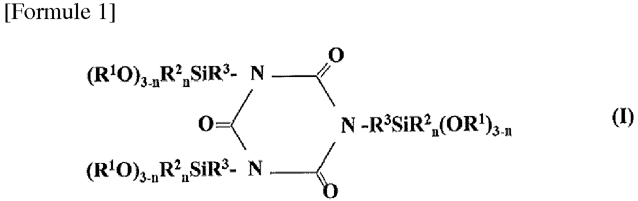 dans laquelle les R¹ et les R² représentent chacun indépendamment un groupe méthyle, un groupe éthyle ou un groupe 2-méthoxyéthyle, les R³ représentent chacun indépendamment un groupe hydrocarbure bivalent ayant 2 à 11 atomes de carbone, et « n » représente 0, 1 ou 2.

5. Film d'étanchéité de pile photovoltaïque tel que défini selon l'une quelconque des revendications 1 à 4, dans lequel l'agent de couplage au silane A est au moins l'un sélectionné dans le groupe constitué du 1,3,5-tris[3-(triméthoxysilyl)propyl]isocyanurate, 1,3,5-tris[3-(triéthoxysilyl)propyl]isocyanurate, du 1,3,5-tris[3-(méthyldiméthoxysilyl)propyl]isocyanurate, et du 1,3,5-tris[3-(méthyldiéthoxysilyl)propyl]isocyanurate.

6. Film d'étanchéité de pile photovoltaïque tel que défini selon l'une quelconque des revendications 1 à 5, dans lequel l'agent de couplage au silane B est représenté par la formule suivante (II): [Formule 2]
**(R⁴O)₃₋ₘR⁵ₘSi-X** (**II**)
dans laquelle R⁴ et R⁵ représentent chacun indépendamment un groupe méthyle, un groupe éthyle ou un groupe 2-méthoxyéthyle, X représente un groupe fonctionnel organique ayant comme groupe terminal un groupe vinyle, un groupe époxy, un groupe styryle, un groupe méthacryloyle, un groupe acryloyle, un groupe amino, un groupe mercapto ou un groupe isocyanate, dont chacun peut avoir un substituant, et « m » représente 0 ou 1.

7. Film d'étanchéité de pile photovoltaïque tel que défini selon l'une quelconque des revendications 1 à 6, dans lequel l'agent de couplage au silane B est au moins l'un sélectionné dans le groupe constitué du 3-méthacryloxypropyltriméthoxysilane, du 3-méthacryloxypropyltriéthoxysilane, N-phényl-3-aminopropyltriméthoxysilane, et du 3-isocyanatopropyltriéthoxysilane.

8. Film d'étanchéité de pile photovoltaïque tel que défini selon l'une quelconque des revendications 1 à 7, qui présente une résistivité volumique après réticulation de 1,0 x 10¹⁶Ω•cm ou plus, qui est déterminée sous une atmosphère de 25°C.

9. Film d'étanchéité de pile photovoltaïque tel que défini selon l'une quelconque des revendications 1 à 8, qui présente une résistance d'adhérence au verre de 20 N/cm ou plus, la résistance étant mesurée selon un test de décollement à 180° (JIS K 6584, 1994), après que le film d'étanchéité soit réticulé et laissé par la suite à une température de 85°C et une humidité de 85 % HR durant 2 000 heures.

10. Film d'étanchéité de pile photovoltaïque tel que défini selon l'une quelconque des revendications 1 à 9, dans lequel le copolymère d'éthylène-monomère polaire est le copolymère d'éthylène-acétate de vinyle.

11. Film d'étanchéité de pile photovoltaïque tel que défini selon l'une quelconque des revendications 1 à 10, dans lequel l'agent de réticulation est un peroxyde organique.

12. Pile photovoltaïque obtenue par scellement étanche d'éléments photovoltaïques dans le(s) film(s) d'étanchéité de pile photovoltaïque tel(s) que défini(s) selon l'une quelconque des revendications 1 à 11.
